# EUROPÄISCHE PATENTSCHRIFT

(11) **EP 2 645 833 B1**
(45) Veröffentlichungstag und Bekanntmachung des Hinweises auf die Patenterteilung: **09.06.2021**
(21) Anmeldenummer: 13159733.8
(22) Anmeldetag: 18.03.2013
(51) Int. Cl.: H05K 5/00, F24C 7/08, F24C 15/10

(54) **Hausgerätevorrichtung**
Domestic appliance
Dispositif d'appareil ménager

(30) Priorität: 29.03.2012 ES 201230469
(43) Veröffentlichungstag der Anmeldung: 02.10.2013
(73) Patentinhaber: BSH Hausgeräte GmbH, 81739 München (DE)
(72) Erfinder: Arnal Valero, Adolfo, 50009 Zaragoza (ES); Ceamanos Gaya, Jesús, 50016 Zaragoza (ES); Llorente Gil, Sergio, 50009 Zaragoza (ES); Martin Gomez, Damaso, 20012 Zaragoza (ES); Palacios Tomas, Daniel, 50008 Zaragoza (ES); Pallares Zaera, Oscar, 50018 Zaragoza (ES)

(56) Entgegenhaltungen:
- EP-A1- 2 045 923
- EP-A1- 2 290 292
- EP-A2- 1 139 695
- EP-A2- 1 798 483
- WO-A1-97/43583
- WO-A1-2006/093475
- DE-A1-102006 030 023
- DE-U1- 20 301 800
- US-A- 5 508 889
- US-A1- 2007 103 882
- US-B1- 6 239 359

## Beschreibung

Die Erfindung geht aus von einem Hausgerät mit einer Hausgerätevorrichtung nach dem Oberbegriff des Anspruchs 1.

Es sind Kochfelder bekannt, die ein Gehäuse und eine Elektronikeinheit, die in dem Gehäuse angeordnet sind, aufweisen. Weiterhin ist es bekannt, eine Elektronikbaugruppe der Elektronikeinheit gegen andere Elektronikbauteile der Elektronikeinheit durch Ausformungen des Gehäuses abzugrenzen.

Die Aufgabe der Erfindung besteht insbesondere darin, eine gattungsgemäße Vorrichtung mit verbesserter Flexibilität hinsichtlich einer Gestaltung, Positionierung und/oder Ausstattung bereitzustellen. Die Aufgabe wird erfindungsgemäß durch die Merkmale des Patentanspruchs 1 gelöst, während vorteilhafte Ausgestaltungen und Weiterbildungen der Erfindung den Unteransprüchen entnommen werden können.

Die Erfindung geht aus von einem Hausgerät mit einer Hausgerätevorrichtung, insbesondere einer Gargerätevorrichtung, vorteilhaft einer Kochfeldvorrichtung, mit zumindest einer Gehäuseeinheit, zumindest einer Elektronikeinheit, die zumindest großteils, insbesondere zu mindestens 70 %, vorteilhaft zu mindestens 85 %, vorzugsweise zu mindestens 95 %, in der Gehäuseeinheit angeordnet ist, und zumindest einer Barriereeinheit, die dazu vorgesehen ist, in zumindest einem montierten Zustand zumindest eine Elektronikbaugruppe der Elektronikeinheit gegen zumindest einen Großteil anderer elektronischer Bauelemente der Elektronikeinheit abzugrenzen.

Es wird vorgeschlagen, dass die Barriereeinheit und die Gehäuseeinheit getrennt voneinander ausgebildet sind. Unter einer "Gehäuseeinheit" einer Hausgerätevorrichtung soll insbesondere eine Einheit verstanden werden, die von zumindest einem Gehäuseteil gebildet ist, die gemeinsam einen Raum bilden, der dazu vorgesehen ist, weitere Bauteile der Hausgerätevorrichtung aufzunehmen. Vorzugsweise sind die Gehäuseteile jeweils an zumindest einer Fläche durch einen Bediener von außen, zumindest in einem montierten Zustand der Hausgerätevorrichtung, vorteilhaft in einem Zustand, der sich von einem Einbauzustand, in dem die Hausgerätevorrichtung in ein Möbelstück integriert ist, unterscheidet, berührbar. Insbesondere ist zumindest eines der Gehäuseteile als Kochfeldplatte und/oder Hausgerätetür ausgebildet. Unter einer "Elektronikeinheit" soll insbesondere eine Einheit verstanden werden, die von elektronischen Bauteilen, insbesondere Spulen, Wiederständen, Kondensatoren und/oder Halbleiterbauteilen, gebildet ist. Insbesondere weist die Elektronikeinheit zumindest ein Leistungsbauteil, insbesondere einen elektrischen Motor, ein elektrisches Heizelement, insbesondere einen Induktor, zumindest eine Leistungselektronik, insbesondere zur Energieversorgung des Leistungsbauteils, und/oder zumindest eine Steuerelektronik, insbesondere zur Steuerung des Leistungsbauteils und/oder der Leistungselektronik, auf. Die Elektronikeinheit weist zumindest eine Leiterplatte auf, die dazu vorgesehen ist, zumindest einen Teil der elektrischen Bauteile der Elektronikeinheit zu tragen, elektrisch leitend miteinander zu verbinden und/oder zu bilden. Die Leiterplatte ist hierbei Teil der Barriereeinheit. Unter einer "Elektronikbaugruppe" soll insbesondere eine Reihen- und/oder Parallelschaltung von zumindest einem, insbesondere zumindest zwei, vorteilhaft zumindest drei, besonders vorteilhaft zumindest vier, vorzugsweise zumindest fünf, insbesondere maximal 20, vorteilhaft maximal 15, vorzugsweise maximal 10, elektronischen Bauelementen verstanden werden, die einem gemeinsamen Zweck dienen. Insbesondere ist die Barriereeinheit dazu vorgesehen, die Elektronikbaugruppe gegen leitfähige Gehäuseteile und/oder gegen Teile die leitfähig mit leitfähigen Gehäuseteilen verbunden sind, abzugrenzen. Insbesondere weist die Barriereeinheit zumindest eine Ablagerungsfläche auf, die zwischen der Elektronikbaugruppe und einem elektronischen Bauteil der Elektronikeinheit und/oder einem Gehäuseteil der Gehäuseeinheit, das durch die Barriereeinheit von der Elektronikbaugruppe abgegrenzt wird, angeordnet ist. Darunter, dass eine Fläche "zwischen" zwei Bauelementen und/oder zwischen einem Bauelement und der Elektronikbaugruppe angeordnet ist, soll insbesondere verstanden werden, dass jedes Strahlbündel mit einem Durchmesser von zumindest 0,1 mm, insbesondere zumindest 0,5 mm, vorteilhaft zumindest 1 mm, das die Bauelemente miteinander und/oder das Bauelement mit zumindest einem beliebigen der Bauelemente der Elektronikbaugruppe verbindet, die Fläche zumindest teilweise schneidet. Insbesondere ist die Barriereeinheit dazu vorgesehen, die Elektronikbaugruppe gegen zumindest 70 %, vorteilhaft zumindest 85%, besonders vorteilhaft zumindest 95 %, vorzugsweise 100 %, der anderen elektronischen Bauelemente und/oder der Bauteile, die als Gehäusebauteile ausgebildet und/oder leitend mit zumindest einem Gehäusebauteil verbunden sind und die einen Abstand von maximal zumindest 5 cm, insbesondere zumindest 10 cm, vorteilhaft zumindest 20 cm, zu der Elektronikbaugruppe aufweisen, abzugrenzen. Insbesondere ist die Ablagerungsfläche dazu vorgesehen, von der Elektronikbaugruppe, insbesondere bei einem, insbesondere kontrollierten und/oder gewolltem, Defekt, emittierte Ionen und/oder Plasma zu adsorbieren. Insbesondere ist die Barriereeinheit dazu vorgesehen, ein Volumen bereitzustellen, in dem sich das Plasma und/oder die Ionen ausbreiten und verdünnen können. Vorzugsweise unterscheidet sich die Barriereeinheit von einer Lackschicht und/oder etwas vergleichbarem, die auf die Elektronikbaugruppe aufgetragen ist. Es kann insbesondere eine freie Platzierbarkeit der Baugruppe innerhalb der Elektronikeinheit erreicht werden. Insbesondere können Entwicklungskosten für eine individuelle Anpassung von Gehäuseeinheiten eingespart werden.

Weiterhin wird vorgeschlagen, dass zumindest die eine Elektronikbaugruppe als Schutzbaugruppe ausgebildet ist. Unter einer Schutzbaugruppe soll insbesondere eine Elektronikbaugruppe verstanden werden, die dazu vorgesehen ist, zumindest einen elektrischen Schaltkreis, der insbesondere zumindest ein Leistungsbauteil aufweist, vor einer Überspannung und/oder vorzugsweise einem Überstrom, insbesondere einer Stromstärke größer als 32 A, insbesondere größer als 25 A, vorteilhaft größer als 20 A, besonders vorteilhaft größer als 16 A, vorzugsweise größer als 10 A, insbesondere ausgelöst durch einen Defekt und/oder Fehler eines anderen elektronischen Bauteils, insbesondere eines elektronischen Bauteils der Leistungselektronik, insbesondere einem Inverter, und/oder einem elektronischen Bauteil der Steuerelektronik, der zu einer Fehlansteuerung führt, zu schützen. Insbesondere ist die Schutzbaugruppe dazu vorgesehen, eine Stromleitung einer Spannungsversorgung, insbesondere eines Hausstromanschlusses, eine Stromleitung eines Spannungswandlers und/oder eine Stromleitung eines Leistungsbauteils zu schützen. Auch sind Schutzbaugruppen denkbar, die bereits bei kleinen Stromstärken, insbesondere bei einem Überschreiten von 1 A oder einem Überschreiten von 0,5 A, eine Trennung der Stromleitung vornehmen. Insbesondere ist die Schutzbaugruppe als Überstromschutzeinrichtung ausgebildet. Alternativ sind Ausgestaltungen als Überspannungsschutzeinrichtung, beispielsweise mit Freilaufdioden, denkbar. Insbesondere weist die Schutzbaugruppe ein elektronisches Bauelement, insbesondere einen elektrischen Leiter, auf, das dazu vorgesehen ist, sich bei einem Überstrom selbst zu zerstören, insbesondere durch Überhitzung zu verdampfen, um eine leitende Verbindung zu unterbrechen. Um eine erhöhte Sicherheit zu gewährleisten, weist die Schutzbaugruppe bevorzugt eine Mehrzahl von in Reihe geschalteten elektronischen Bauelementen auf, die dazu vorgesehen sind, bei einem Überstrom eine Verbindung zu trennen. Besonders beschriebene Schutzbauteile sind einem erhöhten Risiko ausgesetzt zerstört zu werden. Um eine erhöhte Sicherheit zu gewährleisten, findet die Erfindung hier vorteilhaft Anwendung.

Ferner wird vorgeschlagen, dass zumindest die eine Elektronikbaugruppe als Leiterbahnbaugruppe ausgebildet ist. Unter einer Leiterbahnbaugruppe soll insbesondere eine Elektronikbaugruppe verstanden werden, deren zumindest ein elektronisches Bauelement von zumindest einer Leiterbahn auf einer Leiterplatte gebildet ist. Insbesondere sind durch eine Breite und/oder Führung der Leiterbahn unterschiedliche Wiederstände, Kapazitäten und/oder Induktivitäten einstellbar. Insbesondere ist die Leiterbahn als elektrischer Wiederstand ausgebildet, der dazu vorgesehen ist, als Überstromschutzeinrichtung zu fungieren. Alternativ ist es denkbar, dass die Leiterbahn als Induktionsspule, insbesondere für einen Stromsensor, ausgebildet ist. Eine Zerstörung dieser Bauelemente, insbesondere durch eine Überspannung, führt, insbesondere auch wenn sie mit einem mechanischen Schutzlack versehen sind, zu einer Freisetzung von Plasma, das leitende Verbindungen zu anderen elektronischen Bauteilen und/oder Gehäusebauteilen herstellen kann. Um eine erhöhte Sicherheit zu gewährleisten, findet die Erfindung hier vorteilhaft Anwendung.

Weiterhin wird vorgeschlagen, dass die Barriereeinheit zumindest ein Barriereelement mit zumindest einem Befestigungselement aufweist, das dazu vorgesehen ist, das Barriereelement mit der Elektronikeinheit zu verbinden. Unter einem Barriereelement soll insbesondere ein Element der Barriereeinheit mit zumindest einer Ablagerungsfläche verstanden werden. Insbesondere ist das Befestigungselement dazu vorgesehen, das Barriereelement mit einer Leiterplatte der Elektronikeinheit zu verbinden. Es kann insbesondere eine preiswerte Befestigung erreicht werden. Insbesondere kann eine erhöhte Sicherheit erreicht werden. Alternativ ist eine Stoffschlussverbindung, insbesondere eine Klebeverbindung, denkbar, um die Barriereeinheit mit der Elektronikeinheit zu verbinden.

Ferner wird vorgeschlagen, dass das Befestigungselement als Rastelement ausgebildet ist. Insbesondere ist das Befestigungselement dazu vorgesehen, mit einem korrespondierenden Rastelement der Elektronikeinheit, insbesondere einem Loch in der Leiterplatine, eine formschlüssige Verbindung einzugehen. Alternativ ist es denkbar, dass das Befestigungselement als Klemmelement ausgebildet ist. Insbesondere ist es denkbar, dass das Befestigungselement dazu vorgesehen ist, mit einem korrespondierenden Klemmelement der Elektronikeinheit eine kraftschlüssige Verbindung einzugehen. Es kann insbesondere eine preiswerte, sichere Lösung bereitgestellt werden.

Weiterhin wird vorgeschlagen, dass die Barriereeinheit zumindest in dem montierten Zustand als zumindest im Wesentlichen geschlossene Umhüllung ausgebildet ist. Es sind zumindest von jedem Bauelement der Elektronikbaugruppe gesehen, vorteilhaft von jedem Punkt innerhalb der Barriereeinheit gesehen, zumindest 95 %, vorteilhaft zumindest 97 %, vorzugsweise zumindest 99 %, des vollen Raumwinkels durch zumindest eine Anlagerungsfläche der Barriereeinheit begrenzt. Es kann insbesondere eine gute Eindämmung für emittierte Ionen und/oder emittiertes Plasma erreicht werden.

Alternativ wird vorgeschlagen, dass die Barriereeinheit zumindest in dem montierten Zustand als teilweise offene Umhüllung ausgebildet ist. Hierbei sind von zumindest jedem Bauelement der Elektronikbaugruppe gesehen maximal 95 %, insbesondere maximal 90 %, und vorteilhaft zumindest 50 %, besonders vorteilhaft zumindest 70 %, vorzugsweise zumindest 85 %, des vollen Raumwinkels durch zumindest eine Anlagerungsfläche der Barriereeinheit begrenzt. Es kann insbesondere eine gute Wärmeabführung von der Elektronikbaugruppe, insbesondere durch Konvektion und/oder Luftbewegung, erreicht werden.

Weiterhin wird vorgeschlagen, dass die Barriereeinheit zumindest im Wesentlichen aus Kunststoff gebildet ist. Insbesondere weist die Barriereeinheit zumindest ein Barriereelement auf, das zu mindestens 50 %, vorteilhaft mindestens 70 %, vorzugsweise mindestens 85 %, von Kunststoff, insbesondere faserverstärktem Kunststoff, vorteilhaft einem Harz, insbesondere Epoxidharz und/oder Phenolharz, alternativ einem Thermoplast, beispielsweise Polybutylenterephthalat oder Polyamid, gebildet ist. Insbesondere weisen die Materialien der Barriereelemente der Barriereeinheit eine Brennbarkeit der V0-Klasse auf. Insbesondere weisen die Materialien der Barriereelemente der Barriereeinheit eine Glühdrahtentzündungstemperatur von zumindest 700 °C, insbesondere zumindest 750 °C, vorteilhaft von zumindest 775 °C, auf. Insbesondere weisen die Materialien der Barriereelemente der Barriereeinheit eine Glühdrahtentflammbarkeitszahl von zumindest 750 °C, insbesondere zumindest 800 °C, vorteilhaft von zumindest 850 °C, auf. Es kann insbesondere eine leichte, preiswerte und/oder einfach zu produzierende Ausgestaltung erreicht werden.

Die Erfindung findet Anwendung in elektrischen Hausgeräten, insbesondere Gargeräten, beispielsweise Mikrowellenherden, Backöfen und/oder Kochfeldern. Weiterhin ist ein Einsatz der Erfindung in Kühlschränken, Geschirrspülern, Waschmaschinen und weiteren Hausgeräten möglich.

Weitere Vorteile ergeben sich aus der folgenden Zeichnungsbeschreibung. In der Zeichnung sind Ausführungsbeispiele der Erfindung dargestellt. Die Zeichnung, die Beschreibung und die Ansprüche enthalten zahlreiche Merkmale in Kombination. Der Fachmann wird die Merkmale zweckmäßigerweise auch einzeln betrachten und zu sinnvollen weiteren Kombinationen zusammenfassen.

Es zeigen:
- Fig. 1: ein erfindungsgemäßes Kochfeld in einer perspektivischen Darstellung,
- Fig. 2: eine erfindungsgemäße Kochfeldvorrichtung mit zwei unterschiedlich ausgestalteten erfindungsgemäßen Barriereeinheiten in einer perspektivischen Darstellung,
- Fig. 3: eine geschnittene Aufsicht entlang der Richtung III auf eine erste der Barriereeinheiten aus Figur 2,
- Fig. 4: eine perspektivische Darstellung eines erfindungsgemäßen Barriereelements einer Barriereeinheit nach Figur 3,
- Fig. 5: eine geschnittene Aufsicht entlang der Richtung V auf eine zweite der Barriereeinheiten aus Figur 2 und
- Fig. 6: eine perspektivische Darstellung eines erfindungsgemäßen Barriereelements einer Barriereeinheit nach Figur 5.

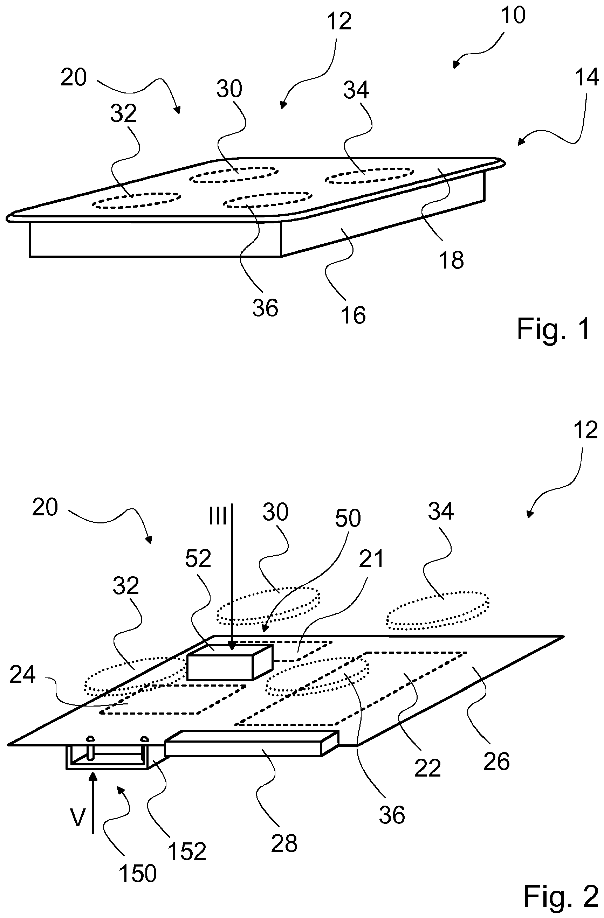

Figur 1 zeigt ein als Kochfeld ausgebildetes Hausgerät 10 mit einer als Kochfeldvorrichtung ausgebildeten Hausgerätevorrichtung 12. Die Hausgerätevorrichtung 12 weist eine Gehäuseeinheit 14 auf. Weiterhin weist die Hausgerätevorrichtung 12 eine Elektronikeinheit 20 auf. Die Elektronikeinheit 20 ist komplett in der Gehäuseeinheit 14 angeordnet. Die Gehäuseeinheit 14 ist von einem ersten, als Aluminiumschale ausgebildeten Gehäuseteil 16 und einem zweiten, als Kochfeldplatte ausgebildeten Gehäuseteil 18 gebildet. Die Elektronikeinheit 20 weist vier, als Heizelemente ausgebildete Leistungsbauteile 30, 32, 34, 36 auf. Die Leistungsbauteile 30, 32, 34, 36 sind unter dem als Kochfeldplatte ausgebildeten Gehäuseteil 18 angeordnet. Durch die Leistungsbauteile 30, 32, 34, 36 sind Kochzonen auf der Kochfeldplatte definiert. Die Leistungsbauteile 30, 32, 34, 36 sind als Induktionsheizelemente ausgebildet. Weiterhin weist die Elektronikeinheit 20 eine Netzanschlusselektronik 21 auf, die dazu vorgesehen ist, an einen Hausstromanschluss angeschlossen zu werden.

Die Elektronikeinheit 20 weist ferner eine Leistungselektronik 22 auf, die dazu vorgesehen ist, die Leistungsbauteile 30, 32, 34, 36 zu versorgen (Figur 2). Die Elektronikeinheit 20 weist weiterhin eine Steuerelektronik 24 auf, die dazu vorgesehen ist, die Leistungselektronik 22 zu steuern. Die Elektronikeinheit 20 weist eine Leiterplatte 26 auf, auf der die Leistungselektronik 22 und die Steuerelektronik 24 angeordnet sind. Die Leiterplatte 26 verbindet Bauelemente der Steuerelektronik 24 untereinander, Bauelemente der Leistungselektronik 22 untereinander und Bauelemente der Steuerelektronik 24 mit Bauelementen der Leistungselektronik 22 miteinander. Am Rand der Elektronikeinheit 20 bzw. am Rand der Leiterplatte 26 ist eine Kühleinheit 28 angeordnet, die zur Kühlung der Leistungselektronik 22 vorgesehen ist. Die Kühleinheit 28 weist einen Kühlkörper und einen Lüfter auf.

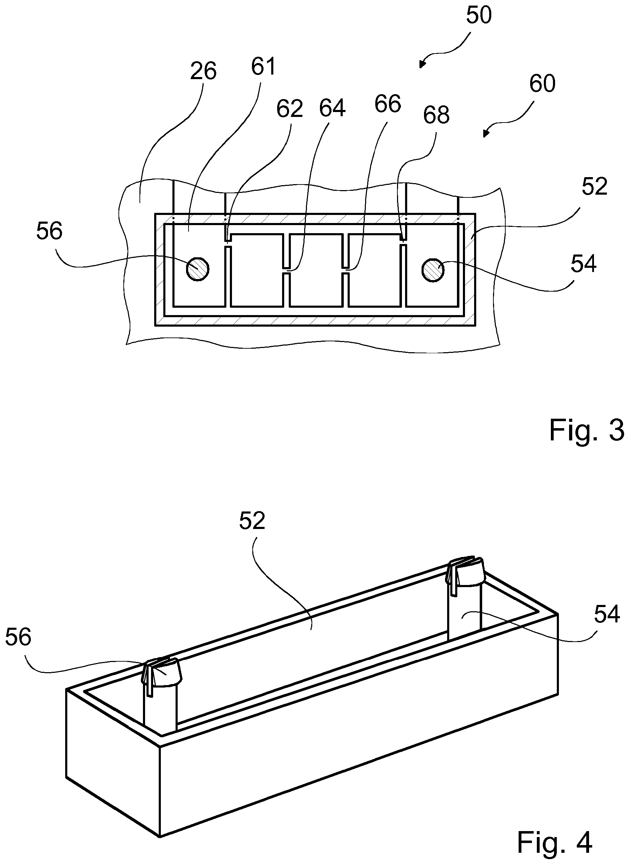

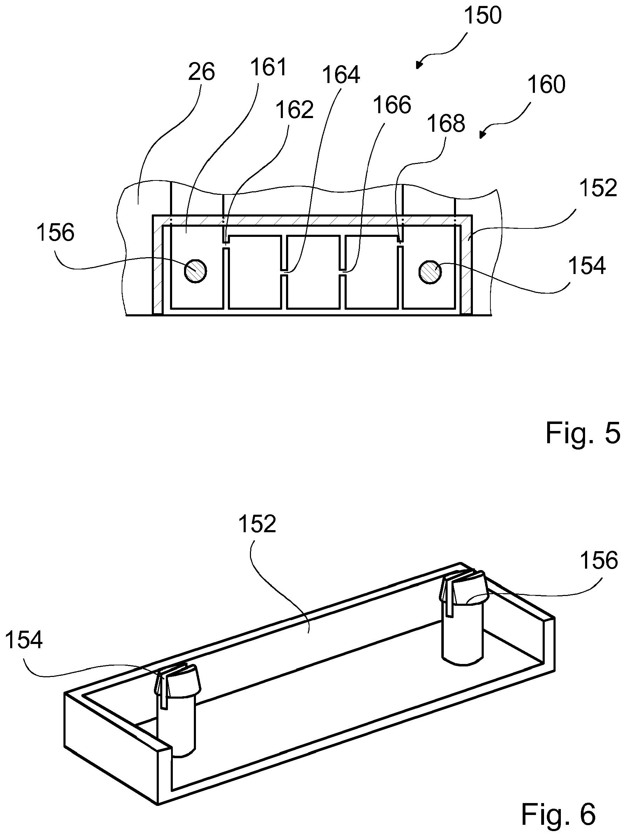

Die Elektronikeinheit 20 weist ein erste und eine zweite Barriereeinheit 50, 150 auf, die dazu vorgesehen ist, in einem montierten Zustand jeweils zumindest eine Elektronikbaugruppe 60, 160 der Elektronikeinheit 20 gegen alle anderen elektronischen Bauelemente der Elektronikeinheit 20 abzugrenzen. Die Barriereeinheiten 50, 150 sind jeweils von der Gehäuseeinheit 14 getrennt ausgebildet. Die Elektronikbaugruppen 60, 160 sind jeweils als Schutzbaugruppe ausgebildet (Figur 3 und 5). Die Elektronikbaugruppen 60, 160 sind als Überstromeinrichtungen ausgebildet. Die Elektronikbaugruppen 60, 160 sind als Leiterbahnbaugruppen ausgebildet. Die Elektronikbaugruppen 60, 160 weisen jeweils 4 von einer Leiterbahn 61, 161 gebildete Sicherungen 62, 64, 66, 68, 162, 164, 166, 168 auf. Die Sicherungen 62, 64, 66, 68, 162, 164, 166, 168 sind als schmale Stellen der Leiterbahn 61, 161 ausgebildet. Die Sicherungen 62, 64, 66, 68, 162, 164, 166, 168 sind jeweils in Reihe geschaltet. Es sind Ausgestaltungen mit anderer Anzahl an Sicherungen, insbesondere zumindest einer, vorteilhaft fünf, aber auch bis zu zehn, denkbar.

Die Barriereeinheiten 50, 150 sind jeweils von der Leiterplatte 26 und einem weiteren Barriereelement 52, 152 gebildet. Die Barriereeinheiten 50, 150 sind im Wesentlichen aus Kunststoff gebildet ist. Die Leiterplatte 26 ist aus faserverstärktem Epoxidharz gebildet. Das Barriereelement 52, 152 ist jeweils aus PBT gebildet. Das Barriereelement 52, 152 weist jeweils zwei Befestigungselemente 54, 56, 154, 156 auf, die dazu vorgesehen sind, das Barriereelement 52, 152 mit der Elektronikeinheit 20 zu verbinden. Die Befestigungselemente 54, 56, 154, 156 sind als Rastelemente ausgebildet. Die Leiterplatte 26 weist korrespondierende, als Löcher ausgebildete Rastmittel auf. Die Befestigungselemente 54, 56, 154, 156 sind einstückig mit den Barriereelementen 52, 152 ausgebildet. Die Befestigungselemente 54, 56, 154, 156 sind als geschlitzte Zapfen ausgebildet. Die Befestigungselemente 54, 56, 154, 156 weisen nahe dem geschlitzten Ende an der Außenkante einen Rastvorsprung auf, der zum Ende hin konisch zuläuft. Bei einer Montage der Barriereelemente 52, 152, bei Stecken der Befestigungselemente 54, 56, 154, 156 durch die korrespondierenden Löcher in der Leiterplatte 26, werden die geschlitzten Zapfen durch den Konus auf der flachen Seite des Rastvorsprungs zum Schlitz hin ausgelenkt. Passiert der Rastvorsprung das Loch der Leiterplatte 26 federt dieser nach außen und verrastet das Barriereelement 52, 152 mit der Leiterplatte 26, bzw. der Elektronikeinheit 20. Durch einen Konus auf der steilen Seite des Rastvorsprungs wird eine Federkraft erzeugt, die das Barriereelement 52, 152 gegen die Leiterplatte 26 presst.

Die erste Barriereeinheit 50 ist in dem montierten Zustand als im Wesentlichen geschlossene Umhüllung ausgebildet (Figuren 3 und 4). Die Barriereeinheit 50 ist dazu vorgesehen, die auf einer Oberseite der Leiterplatte 26 zwischen anderen elektronischen Bauelementen der Elektronikeinheit 20 angeordnete Elektronikbaugruppe 60 gegen die anderen elektronischen Bauelemente abzugrenzen. Das Barriereelement 52 der Barriereeinheit 50 ist als einseitig offener, länglicher Kasten ausgebildet. Das Barriereelement 52 ist auf der Oberseite der Leiterplatte 26, an der ein Großteil der anderen elektronischen Bauelemente der Elektronikeinheit 20 angeordnet ist, angeordnet. Das Barriereelement 52 ist mit der offenen Seite in Richtung der Leiterplatte 26 ausgerichtet. Das Barriereelement 52 weist in einem montierten Zustand, ausgehend von der Leiterplatte 26, eine Höhe von 22 mm auf. An der Oberseite der Leiterplatte 26 steht viel Bauraum zur Verfügung, da hier auch andere hohe elektronische Bauelemente verbaut sind. Dies wiederum ermöglicht eine Ausgestaltung des Barriereelements 52 mit dieser Höhe. Durch die große Höhe kann sich bei einem Schaden, also einem Verdampfen, der Sicherung 62, 64, 66, 68 entstehendes Plasma gut verteilen und der Stromfluss, insbesondere durch einen Lichtbogen, wird schnell unterdrückt. Eine Breite und eine Länge des Barriereelements 52 betragen 2 cm und 5 cm. In Abhängigkeit von einer Ausgestaltung der Elektronikbaugruppe 60 können Breite und Länge des Barriereelements 52 zwischen 5 mm und 35 mm, bzw. zwischen 2 cm und 10 cm liegen. Die Befestigungselemente 54, 56 sind nahe Endbereichen des Barriereelements 52 an einer Innenseite angeordnet.

Die zweite Barriereeinheit 150 ist in dem montierten Zustand als teilweise offene Umhüllung ausgebildet (Figuren 5 und 6). Die Barriereeinheit 150 ist dazu vorgesehen, die auf einer Unterseite der Leiterplatte 26 in einem Randbereich der Elektronikeinheit 20 angeordnete Elektronikbaugruppe 160 gegen andere elektronische Bauelemente abzugrenzen. Die Elektronikbaugruppe 160 ist in einem Randbereich der Leiterplatte 26 angeordnet. Das Barriereelement 152 der Barriereeinheit 150 ist als zweiseitig offener, länglicher Kasten ausgebildet, wobei die beiden offenen Seiten aneinander grenzen. Die beiden offenen Seiten sind Längsseiten des Barriereelements 152. Das Barriereelement 152 ist auf der Unterseite der Leiterplatte 26, an der nur wenige der anderen elektronischen Bauelemente der Elektronikeinheit 20 angeordnet sind, angeordnet. Das Barriereelement 152 ist mit der breiteren der offenen Seiten in Richtung der Leiterplatte 26 ausgerichtet. Die andere offene Seite ist zum nächsten Rand der Leiterplatte 26 hin ausgerichtet. Das Barriereelement 152 schließt an den Rand der Leiterplatte 26 an. Das Barriereelement 152 ist neben der Kühleinheit 28 angeordnet. Das Barriereelement 152 weist in einem montierten Zustand, ausgehend von der Leiterplatte 26, eine Höhe von 4 mm auf. An der Unterseite der Leiterplatte 26 steht nur wenig Bauraum zur Verfügung, da hier die Gehäuseeinheit 14 nahe ist. Die Befestigungselemente 154, 156 sind nahe Endbereichen des Barriereelements 152 an einer Innenseite angeordnet. Durch die Öffnung zur Seite kann sich bei einem Schaden, also einem Verdampfen, der Sicherung 162, 164, 166, 168 entstehendes Plasma gut verteilen und der Stromfluss, insbesondere durch einen Lichtbogen, wird schnell unterdrückt. Ebenso verhindert die Barriereeinheit 150 einen Lichtbogen zwischen einer defekten Elektronikbaugruppe 160 und der Gehäuseeinheit 14.

In alternativen Ausgestaltungen ist es denkbar, dass ein Barriereelement kleine Löcher, insbesondere Nadellöcher, aufweist, um eine Wärmeabfuhr zu verbessern. Weiterhin ist es denkbar, eine Barriereeinheit vergleichbar der ersten Barriereeinheit 50 auf der Unterseite der Leiterplatte 26 anzuordnen, wobei eine Höhe eines Barriereelements auf 4 mm beschränkt ist. Ebenso ist es denkbar, eine Barriereeinheit vergleichbar der zweiten Barriereeinheit 150 in einem Randbereich auf der Oberseite der Leiterplatte anzuordnen, wobei eine größerer Höhe, insbesondere in Anbetracht besserer Platzverhältnisse, von bis zu 22 mm oder mehr Anwendung finden kann. Als Oberseite soll hierbei jeweils die Seite der Leiterplatte 26 verstanden werden, auf der die meisten elektronischen Bauelemente angeordnet sind.

In einer weiteren Ausgestaltungsform ist es denkbar, dass eine von einer Leiterbahn gebildete Sicherung zusätzlich zu einer Einhüllung mit einer Barriereinheit mit einer Kaptonfolie und/oder etwas vergleichbarem überklebt ist, um verbesserte Sicherungseigenschaften zu erreichen.

**Bezugszeichen**

| | | | |
|---|---|---|---|
| 10 | Hausgerät | 152 | Barriereelement |
| 12 | Hausgerätevorrichtung | 154 | Befestigungselement |
| 14 | Gehäuseeinheit | 156 | Befestigungselement |
| 16 | Gehäuseteil | 160 | Elektronikbaugruppe |
| 18 | Gehäuseteil | 161 | Leiterbahn |
| 20 | Elektronikeinheit | 162 | Sicherung |
| 21 | Netzanschlusselektronik | 164 | Sicherung |
| 22 | Leistungselektronik | 166 | Sicherung |
| 24 | Steuerelektronik | 168 | Sicherung |
| 26 | Leiterplatte | | |
| 28 | Kühleinheit | | |
| 30 | Leistungsbauteil | | |
| 32 | Leistungsbauteil | | |
| 34 | Leistungsbauteil | | |
| 36 | Leistungsbauteil | | |
| 50 | Barriereeinheit | | |
| 52 | Barriereelement | | |
| 54 | Befestigungselement | | |
| 56 | Befestigungselement | | |
| 60 | Elektronikbaugruppe | | |
| 61 | Leiterbahn | | |
| 62 | Sicherung | | |
| 64 | Sicherung | | |
| 66 | Sicherung | | |
| 68 | Sicherung | | |
| 150 | Barriereeinheit | | |

## Patentansprüche

1. Hausgerät, welches zumindest eine Hausgerätevorrichtung mit zumindest einer Gehäuseeinheit (14), mit zumindest einer Elektronikeinheit (20), die zumindest Großteils in der Gehäuseeinheit (14) angeordnet ist und die zumindest eine Leiterplatte (26) aufweist, welche dazu vorgesehen ist, zumindest einen Teil elektrischer Bauteile der Elektronikeinheit (20) zu tragen, elektrisch leitend miteinander zu verbinden und/oder zu bilden, und mit zumindest einer Barriereeinheit (50, 150), die dazu vorgesehen ist, in zumindest einem montierten Zustand zumindest eine Elektronikbaugruppe (60, 160) der Elektronikeinheit (20) gegen zumindest einen Großteil anderer elektronischer Bauelemente der Elektronikeinheit (20) abzugrenzen, aufweist, wobei die Barriereeinheit (50, 150) und die Gehäuseeinheit (14) getrennt voneinander ausgebildet sind und die Barriereeinheit (50, 150) zumindest im Wesentlichen aus Kunststoff gebildet ist, **dadurch gekennzeichnet, dass** die Leiterplatte (26) Teil der Barriereeinheit (50,150) ist und die Barriereeinheit (50,150) zumindest in dem montierten Zustand als teilweise offene Umhüllung, wobei von zumindest jedem Bauelement der Elektronikbaugruppe (60, 160) gesehen maximal 95 % des vollen Raumwinkels durch zumindest eine Anlagerungsfläche der Barriereeinheit (50, 150) begrenzt sind, oder zumindest in dem montierten Zustand als zumindest im Wesentlichen geschlossene Umhüllung, wobei zumindest von jedem Bauelement der Elektronikbaugruppe (60, 160) gesehen, zumindest 95 % des vollen Raumwinkels durch zumindest die Anlagerungsfläche der Barriereeinheit (50, 150) begrenzt sind, ausgebildet ist, wobei zumindest die eine Elektronikbaugruppe (60, 160) als Schutzbaugruppe ausgebildet ist, wobei die Schutzbaugruppe eine Elektronikbaugruppe (60, 160) ist, die dazu vorgesehen ist, zumindest einen elektrischen Schaltkreis vor einer Überspannung und/oder einem Überstrom zu schützen.

2. Hausgerät nach Anspruch 1, **dadurch gekennzeichnet, dass** zumindest die eine Elektronikbaugruppe (60, 160) als Leiterbahnbaugruppe ausgebildet ist, wobei die Leiterbahnbaugruppe eine Elektronikbaugruppe (60, 160) ist, deren zumindest ein elektronisches Bauelement von zumindest einer Leiterbahn auf einer Leiterplatte gebildet ist.

3. Hausgerät nach einem der vorhergehenden Ansprüche, **dadurch gekennzeichnet, dass** die Barriereeinheit (50, 150) zumindest ein Barriereelement (52, 152) mit zumindest einem Befestigungselement (54, 56, 154, 156) aufweist, das dazu vorgesehen ist, das Barriereelement (52, 152) mit der Elektronikeinheit (20) zu verbinden.

4. Hausgerät nach Anspruch 3, **dadurch gekennzeichnet, dass** das Befestigungselement (54, 56, 154, 156) als Rastelement ausgebildet ist.

## Claims

1. Household appliance, which has at least one household appliance device with at least one housing unit (14), with at least one electronics unit (20), which is arranged at least largely in the housing unit (14) and which has at least one printed circuit board (26), which is provided to support at least some of the electrical components of the electronics unit (20), to connect and/or form the same in an electrically conducting manner with one another, and with at least one barrier unit (50, 150), which is provided, at least in an assembled state, to delimit at least one electronics module (60, 160) of the electronics unit (20) from at least a majority of other electronic components of the electronics unit (20), wherein the barrier unit (50, 150) and the housing unit (14) are embodied separately from one another and the barrier unit (50, 150) is formed at least substantially from plastic, **characterised in that** the printed circuit board (26) is part of the barrier unit (50, 150) and the barrier unit (50, 150), at least in the assembled state, as a partially open enclosure, wherein viewed from at least each component of the electronics module (60, 160), at most 95% of the full spatial angle is delimited by at least one attachment surface of the barrier unit (50, 150), or at least in the assembled state as an at least essentially closed enclosure, wherein viewed at least from each component of the electronics module (60, 160), at least 95% of the full spatial angle is delimited by at least the attachment surface of the barrier unit (50, 150), wherein at least the one electronics module (60, 160) is embodied as a protective module, wherein the protective module is an electronics module (60, 160), which is provided to protect at least one electric circuit from an overvoltage and/or an overcurrent.

2. Household appliance according to claim 1, **characterised in that** at least the one electronics module (60, 160) is embodied as a conductor path module, wherein the conductor path module is an electronics module (60, 160), the at least one electronic component of which is formed by at least one conductor path on a printed circuit board.

3. Household appliance according to one of the preceding claims, **characterised in that** the barrier unit (50, 150) has at least one barrier element (52, 152) with at least one fastening element (54, 56, 154, 156) which is provided to connect the barrier element (52, 152) to the electronics unit (20).

4. Household appliance according to claim 3, **characterised in that** the fastening element (54, 56, 154, 156) is embodied as a latching element.

## Revendications

1. Appareil ménager, lequel comprend au moins un dispositif d'appareil ménager avec au moins une unité de carcasse (14), avec au moins une unité électronique (20), disposée au moins en grande partie dans l'unité de carcasse (14) et qui présente au moins un circuit imprimé (26), lequel est prévu afin de porter au moins une partie des composants électriques de l'unité électronique (20), de les relier l'un à l'autre et/ou de les constituer de façon électriquement conductrice, et avec au moins une unité barrière (50, 150), prévue afin de délimiter au moins dans un état monté au moins un module électronique (60, 160) de l'unité électronique (20) par rapport à au moins une grande partie d'autres composants électroniques de l'unité électronique (20), dans lequel l'unité barrière (50, 150) et l'unité de carcasse (14) sont formées séparément l'une de l'autre et l'unité barrière (50, 150) est au moins essentiellement formée en matière plastique, **caractérisé en ce que** le circuit imprimé (26) fait partie de l'unité barrière (50,150) et l'unité barrière (50, 150) est formée au moins à l'état monté sous la forme d'une enveloppe partiellement ouverte, dans lequel vu d'au moins chaque composant du module électronique (60, 160) maximum 95 % de l'angle solide plein sont limités par au moins une surface de réticulation de l'unité barrière (50, 150), ou est formée au moins à l'état monté sous la forme d'une enveloppe au moins essentiellement fermée, dans lequel vu d'au moins chaque composant du module électronique (60, 160), au moins 95 % de l'angle solide plein sont limités par au moins la surface de réticulation de l'unité barrière (50, 150), dans lequel au moins un module électronique (60, 160) est formé sous la forme d'un module de protection, dans lequel le module de protection est un module électronique (60, 160) prévu afin de protéger au moins un circuit électrique d'une surtension et/ou d'une surintensité.

2. Appareil ménager selon la revendication 1, **caractérisé en ce qu'au** moins un module électronique (60, 160) est formé sous la forme d'un module à piste conductrice, dans lequel le module à piste conductrice est un module électronique (60, 160), dont l'au moins un composant électronique d'au moins une piste conductrice est formé sur un circuit imprimé.

3. Appareil ménager selon l'une des revendications précédentes, **caractérisé en ce que** l'unité barrière (50, 150) présente au moins un élément barrière (52, 152) avec au moins un élément de fixation (54, 56, 154, 156) prévu afin de relier l'élément barrière (52, 152) à l'unité électronique (20).

4. Appareil ménager selon la revendication 3, **caractérisé en ce que** l'élément de fixation (54, 56, 154, 156) est formé sous la forme d'un élément d'encliquètement.
